# EUROPÄISCHE PATENTSCHRIFT

(11) **EP 2 633 543 B1**
(45) Veröffentlichungstag und Bekanntmachung des Hinweises auf die Patenterteilung: **18.03.2015**
(21) Anmeldenummer: 11764469.0
(22) Anmeldetag: 08.09.2011
(51) Int. Cl.: H01J 3/02, H01J 37/077, H01J 37/075

(54) **VORRICHTUNG ZUM ERZEUGEN EINES ELEKTRONENSTRAHLS**
DEVICE FOR PRODUCING AN ELECTRON BEAM
DISPOSITIF DE PRODUCTION D'UN FAISCEAU ÉLECTRONIQUE

(30) Priorität: 25.10.2010 DE 102010049521
(43) Veröffentlichungstag der Anmeldung: 04.09.2013
(73) Patentinhaber: Fraunhofer-Gesellschaft zur Förderung der angewandten Forschung e.V., 80686 München (DE)
(72) Erfinder: MATTAUSCH, Gösta, 01454 Ullersdorf (DE); FEINÄUGLE, Peter, 88633 Heiligenberg (DE); KIRCHHOFF, Volker, 01829 Wehlen (DE); WEISKE, Dieter, 01239 Dresden (DE); FLASKE, Henrik, 01157 Dresden (DE); ZEIBE, Rainer, 01471 Radeburg (DE)
(86) Internationale Anmeldenummer: PCT/EP2011/004517
(87) Internationale Veröffentlichungsnummer: WO 2012/055458

(56) Entgegenhaltungen:
- DE-A1- 2 741 363
- SU-A1- 813 536
- US-A- 3 430 091
- Luckas-bot et al.: "Austrittsarbeit - Wikipedia", Wikipedia , 25. Juli 2010 (2010-07-25), XP002665086, Gefunden im Internet: URL:http://de.wikipedia.org/w/index.php?ti tle=Austrittsarbeit&oldid=77048061 [gefunden am 2011-12-05]

## Beschreibung

Die Erfindung betrifft eine Vorrichtung zum Erzeugen eines Elektronenstrahls. Insbesondere kann mit einer erfindungsgemäßen Vorrichtung ein "schlanker" Elektronenstrahl mit kleinem Fokusdurchmesser und hoher Leistungsdichte erzeugt und an einem definierten Prozessort innerhalb einer Vakuumkammer zur Einwirkung gebracht werden, wobei sich der Strahlerzeuger und dessen Versorgungsbaugruppen durch kompakten Aufbau, Wartungsfreundlichkeit und relativ geringe Herstellkosten auszeichnen. Typische technologische Anwendungsgebiete für einen erfindungsgemäßen Elektronenstrahlerzeuger sind das Beschichten von Substraten mit Funktionsschichten (wie z. B. Schichten für Korrosionsschutz, Dekor, Diffusionsbarrieren, EMV-Schirmung, Wärmedämmung usw.) durch physikalische Dampfabscheidung (PVD), das Reinigen und Umschmelzveredeln von Metallen im Vakuum sowie das stoffschlüssige Fügen von Bauteilen mittels Schmelzschweißen.

### Stand der Technik

Das Veredeln von Halbzeugen und Produkten durch dekorative oder funktionale Dünnschichtsysteme ist ein wichtiges Arbeitsgebiet der Oberflächentechnik. Große Verbreitung in Produktionsprozessen haben dabei die vielseitigen, umweltfreundlichen und ökonomischen Verfahren der physikalischen Dampfabscheidung (PVD) gefunden, bei denen das Beschichtungsmaterial im Vakuum zunächst verdampft wird und dann, mitunter auch unter Zugabe von Reaktivgasen, auf den jeweiligen Substraten in kontrollierter Weise als Film kondensiert. Wichtige Kriterien für die Auswahl eines geeigneten Beschichtungsverfahrens unter den verschiedenen verfügbaren Technologien sind neben der erzielbaren Morphologie, Reinheit und Haftung der abzuscheidenden Schicht vor allem auch deren Aufwachsgeschwindigkeit sowie Investitionsbedarf und Betriebskosten für den Verdampfer, da von diesen Kenngrößen die Ökonomie des Prozesses maßgeblich abhängt.

Elektronenstrahlquellen unterschiedlicher Bauart werden seit vielen Jahrzehnten zum Umsetzen industrieller Hochrate-PVD-Verfahren eingesetzt. Elektronenstrahl-Verdampfer liefern die höchsten großtechnisch etablierten Beschichtungsraten bei gleichzeitig exzellenter Gleichmäßigkeit und Reinheit der abgeschiedenen Schicht, und das auch für reaktive, ferromagnetische und hochschmelzende Schichtmaterialien. Diese Charakteristika resultieren aus der hohen, durch magnetische Fokussierung und Strahlführung trägheitsfrei einstellbaren Leistungsflussdichte sowie der direkten Heizung der dampfabgebenden Oberfläche, wodurch die zur Speicherung des Beschichtungsmaterials benötigten Tiegel gekühlt werden können und somit keine Kontaminationen der Beschichtung hervorrufen.

Als Elektronenquellen für industrielle PVD-Prozesse sind gegenwärtig ausschließlich auf hohe Betriebstemperatur geheizte Kathoden etabliert, bei denen das Erzeugen freier Elektronen auf dem glühelektrischen Effekt beruht (GB 1 041 282 A). Das Funktionsprinzip dieser auch als "thermionische Kathoden" bezeichneten Elektroden bedingt, dass die traditionellen Elektronenstrahler konstruktiv kompliziert und hinsichtlich ihrer Stromversorgungseinrichtungen relativ aufwändig ausgeführt sind und dass bestimmte Ausführungsformen nur einen stark eingeschränkten Bereich technologischer Anwendungen abdecken können.

Eine weitverbreitete Dampfquelle für das Elektronenstrahlverdampfen (auch "EB-PVD" bezeichnet) sind beispielsweise die so genannten transversalen Elektronenstrahlquellen (auch "transverse EB guns" genannt), bei denen Strahlerzeugung, magnetische 270°-Strahlumlenkung und Tiegel mit Verdampfungsgut zumeist in einem kompakten Funktionsblock integriert sind. Diese Quellen sind relativ preiswert, jedoch in ihrer maximalen Strahlleistung (ca. 20 kW) sowie Beschleunigungsspannung (ca. 20 kV) und damit auch hinsichtlich der erzeugbaren Verdampfungsrate limitiert. Zudem befindet sich die eigentliche Strahlquelle (Kathode mit Heizeinrichtung) auf dem Druckniveau der Beschichtungskammer und ist den darin befindlichen Dämpfen und Gasen direkt ausgesetzt.

Infolgedessen muss der Druck in der Beschichtungskammer durch entsprechend großzügige Dimensionierung der Vakuumpumpen auf niedrige Werte gehalten werden, um Instabilitäten beim Betrieb der Elektronenquelle zu vermeiden. Bei der Hochrate-Abscheidung dielektrischer Verbindungen, die zum Sichern einer anforderungsgerechten Stöchiometrie eine reaktive Prozessführung, d. h. das Einstellen eines relativ hohen Partialdrucks (in etwa 0.1 Pa bis 1.0 Pa) von Reaktivgasen innerhalb der Vakuumkammer, bedingt, haben sich "transverse EB guns" trotz zahlreicher konstruktiver oder schaltungsseitiger Verbesserungen nicht durchsetzen können, insbesondere wegen ihrer unter diesen Prozessbedingungen inakzeptabel hohen Neigung zu Hochspannungsüberschlägen.

Ein technologisch leistungsfähigeres Strahlwerkzeug für die EB-PVD sind so genannte axiale Elektronenstrahlquellen ("axial EB guns"), die für Verdampfungsverfahren mit Strahlleistungen bis zu 300 kW und Beschleunigungsspannungen bis zu 60 kV (für Sonderanwendungen auch bis zu 75 kV) ausgelegt werden. Die Kathodenkammer derartiger Strahlerzeuger wird durch Blenden mit kleiner, zumeist kreisförmiger Öffnung für den Durchtritt des Strahls, die vakuumtechnisch als Strömungswiderstände fungieren, von der Prozesskammer getrennt und separat mit zusätzlichen Hochvakuumpumpen (bei zeitgemäßen Ausführungsformen mittels Turbomolekularpumpen) evakuiert. Damit kann der Verdampfungsprozess auch noch bei höheren Drücken und insbesondere auch mit einem hohen Anteil von Reaktivgasen in der Beschichtungskammer gefahren werden. Desweiteren werden hierbei größere Beschichtungsraten ohne Stabilitätseinbußen erreicht. Allerdings sind derartige Systeme hinsichtlich der notwendigen Investitionskosten recht aufwändig und können daher aus ökonomischen Gründen ebenfalls nur in einem engen Anwendungsbereich vorteilhaft eingesetzt werden.

Um diese Limitierung zu überwinden, sind verschiedentlich Kaltkathoden-Strahlerzeuger mit Plasma-Anode, bei denen die Elektronenfreisetzung nicht auf dem glühelektrischen Effekt beruht, sondern aus dem Ionenbeschuss einer großflächigen Metall-Elektrode resultiert, vorgeschlagen worden (SU 813 536 A1; G. Mattausch et al.: "Cold Cathode Electron Beam Sources for High-Rate PVD" 2010 Society of Vacuum Coaters 505/856-7188, 53rd Annual Technical Conference Proceedings, Orlando, FL April 17-22, 2010, S. 273-279). Eine in der Strahlquelle unterhaltene Hochspannungs-Glimmentladung produziert hierbei Ionen und beschleunigt diese zur Kathode. Die dort ballistisch aus dem Festkörper ins Vakuum überführten Elektronen werden im Kathodenfall des Plasmas beschleunigt und durch geeignete Elektrodenkonturen zu einem homozentrischen Strahl formiert, der mit herkömmlichen elektronenoptischen Baugruppen fokussiert und beispielsweise zu einem Verdampfer gelenkt werden kann.

Eine alternative Anwendung für einen Kaltkathoden-Strahlerzeuger ist aus DE 27 41 363 A1 bekannt. Bei dieser Vorrichtung besteht die von einer Kühleinrichtung gekühlte Kaltkathode aus einem zentralen ersten und vornehmlich Aluminium enthaltenden Material, das von einem zweiten Material, wie beispielsweise einem Edelstahl umschlossen ist und wird verwendet, um eine lumineszierende Strahlung auszubilden.

Während glühelektrische Emitter ein Hochvakuum besser als 10⁻³ Pa in der Kathodenkammer erfordern, liegt der Betriebsdruck bei einer plasmastimulierten Kaltkathode - je nach Betriebsspannung, Plasma-Arbeitsgas und aktuell abgefordertem Entladungsstrom-im Bereich von 2 bis 10 Pa. Auf eine differentielle Evakuierung der Strahlquelle kann daher bis zu einem Druck von ca. 1 Pa in der Beschichtungskammer verzichtet werden, ohne die wesentlichen Vorteile der Axialstrahler, wie technologische Universalität sowie räumliche und vakuumtechnische Separation von Verdampfer und Strahlquelle und den damit verbundenen Gewinn an Zuverlässigkeit, aufzugeben. Das Regeln der Strahlleistung erfolgt dabei durch Variation der Plasmadichte in der Kathodenkammer mittels einer schnellen Gasflussregelung. Anstelle der bisher üblichen mehradrigen Hochspannungszuführung bei thermionischen Kathoden genügt ein einpoliges Kabel, und die Hochspannungsversorgung benötigt auch kein zusätzliches, auf hohem Potential floatendes Netzteil. Als wirtschaftlich bedeutsames Ergebnis ist hervorzuheben, dass sich auf der Basis von Kaltkathodenstrahlern realisierte Systeme, bestehend aus einer Strahlquelle einschließlich ihrer Versorgungs- und Steuerungskomponenten, gegenüber herkömmlichen Axialstrahler-Systemen zu deutlich niedrigeren Kosten herstellen lassen.

Die beschriebenen Kaltkathoden-Axialstrahler besitzen also gegenüber konventionellen Glühkathoden-Strahlern viele Vorzüge, weisen jedoch auch bei bestimmten technischen Parametern oder für spezielle Anwendungen einige Unzulänglichkeiten auf. So erfordert es die relativ niedrige erzielbare Emissionsstromdichte der Kaltkathode (100 mA/cm² gegenüber bis zu 10 A/cm² bei einer Wolfram-Glühkathode), für hohe Ströme Großflächenkathoden zu implementieren. Daraus resultieren ein tendenziell größerer Strahldurchmesser und eine niedrigere Leistungsdichte am Prozessort. Die Baugröße der Strahlquelle steigt somit im Hochleistungsbereich wieder in unerwünschter Weise an. Desweiteren wird die Elektronenoptik aufwändiger, während generell die Verdampfungsrate etwas geringer als bei konventionellen Systemen mit der gleichen Nennleistung ist.

Das zur Unterhaltung der Hochspannungs-Glimmentladung in der Kathodenkammer benötigte Arbeitsgas strömt durch die zur Strahlauskopplung notwendige axiale Öffnung permanent in die Prozesskammer ein, da zum Regeln der Entladung im Strahler selbst stets ein leichter Überdruck gegenüber der Prozesskammer aufrechterhalten werden muss. Diese Gaslast muss vom Vakuumsystem der Prozesskammer zusätzlich zum technologisch bedingten Gasanfall abgepumpt werden.

Zum Sichern eines akzeptablen Wirkungsgrades (Verhältnis zwischen auskoppelbarer Strahlleistung und der in die Entladung gespeisten Gesamtleistung, Zielwert: > 90%) sind zudem reaktive Komponenten wie beispielsweise Sauerstoff oder Kohlendioxid im Plasma-Arbeitsgas erforderlich, die zum Ausbilden und Stabilisieren dielektrischer Beläge auf der Kathodenoberfläche und somit zum Erhöhen ihrer Sekundärelektronenausbeute (emittierte Elektronen pro einfallendes Ion) dienen. Technologisch betrachtet ist jedoch dieses Vorgehen für Prozesse mit hohen Inertisierungs- bzw. Reinheits-Anforderungen problematisch, und systemtechnisch verursacht es einen zusätzlichen Aufwand beim Handling der gegenüber metallisch blanken Elektrodenoberflächen signifikant erhöhten Rate von Hochspannungsüberschlägen.

Die konkurrierenden Forderungen nach Feldstärke-Entlastung für die Kathode (hierfür werden große Elektroden-Abstände angestrebt) und sicherer Dunkelfeld-Schirmung (hierfür sind kleine Elektroden-Abstände vorteilhaft) machen es bei plasmabasierten Strahlquellen mit wachsendem Arbeitsdruck immer schwieriger, hohe Beschleunigungsspannungen langzeitstabil aufrecht zu erhalten. Bisher im Hochleistungsbereich mit Kaltkathodenstrahlern beherrschte Betriebsspannungen um 30 kV sind für Hochvakuum-Beschichtungsverfahren wie z. B. das Metallisieren (bei ca. 0.001 bis 0.01 Pa) ausreichend. Für reaktive Hochrate-Beschichtungsprozesse mit typischerweise deutlich höherem Druck in der Prozesskammer (ca. 0.1 bis 1 Pa) wären aber wegen des damit besseren Energietransportvermögens des Strahls Spannungen im Bereich von 40 bis 60 kV zweckmäßiger.

Die aus dem Ionenbombardement resultierende Verlustleistung an der Kathode ist mit größenordnungsmäßig ca. 5% der ausgekoppelten Strahlleistung relativ hoch. Eine direkte Wasserkühlung der Kathode ist daher bei hohen Strahlleistungen unumgänglich. Dies ist aber aus zwei Gründen unvorteilhaft. Zum einen bringt man das Kühlwasser in Kontakt mit der Hochspannung führenden Elektrode. Es müssen daher zum verluststromarmen Abbau dieser Potentialdifferenz einige Meter (Richtwert: > 1 m / 5 kV, jeweils für Hin- und Rücklauf) sowie zur Sicherstellung hinreichenden Personenschutzes speziell sicherheitsisolierter Schläuche verlegt werden. Zum anderen muss der Wasserkreislauf bei jedem Kathodenwechsel arbeitsintensiv gesperrt, ausgeblasen und geöffnet werden.

### Aufgabenstellung

Der Erfindung liegt daher das technische Problem zugrunde, eine Vorrichtung zum Erzeugen eines Elektronenstrahls zu schaffen, mittels der die Nachteile des Standes der Technik überwunden werden können. Insbesondere soll mit der Vorrichtung ein schlanker Elektronenstrahl mit kleinem Fokusdurchmesser und hoher Leistungsdichte bei gleichzeitig einfacher Bauform und Systemkonfiguration erzeugbar sein.

Die Lösung des technischen Problems ergibt sich durch Gegenstände mit den Merkmalen des Patentanspruchs 1. Weitere vorteilhafte Ausgestaltungen der Erfindung ergeben sich aus den abhängigen Patentansprüchen.

Eine erfindungsgemäße Vorrichtung umfasst ein Gehäuse, welches zumindest in einem Bereich einen evakuierbaren Raum begrenzt. Durch einen Einlass im Gehäuse wird ein Arbeitsgas in den evakuierbaren Raum eingelassen, damit zwischen einer flächigen Kathode und einer zugehörigen Anode, die beide im evakuierbaren Raum (nachfolgend auch Kathodenkammer genannt) angeordnet sind, ein Glimmentladungsplasma ausgebildet werden kann. Hierfür wird zwischen der Kathode und der Anode mittels einer Stromversorgungseinrichtung eine elektrische Spannung geschaltet. Als Stromversorgungseinrichtung können alle aus dem Stand der Technik bekannten Hochspannungsgeräte eingesetzt werden, welche die technologieseitig geforderten Spannungen (typischerweise < 10³ kV) und Ströme (typischerweise < 25 A) bereitstellen können. Ionen aus dem Glimmentladungsplasma werden in Richtung Kathode beschleunigt und lösen beim Auftreffen auf der Kathodenoberfläche Sekundärelektronen heraus, die im Kathodenfall beschleunigt und zum Elektronenstrahl formiert werden, der durch eine Elektronenstrahlaustrittsöffnung aus dem Gehäuse heraus und dann weiter zu einem Prozessort geführt wird. Insoweit ähnelt eine erfindungsgemäße Vorrichtung einem Elektronenstrahlerzeuger mit Kaltkathode, bei dem der Elektronenstrahl auf Basis einer Glimmentladung erzeugt wird.

Ein wesentliches Merkmal einer erfindungsgemäßen Vorrichtung ist in der besonderen Ausgestaltung der flächigen Kathode begründet. Diese umfasst mindestens zwei Teile, die aus elektrisch leitfähigen, aber ansonsten unterschiedlichen Materialien bestehen. In einem zentralen ersten Oberflächenbereich besteht die Kathode einer erfindungsgemäßen Vorrichtung aus mindestens einem ersten Material, welches sowohl eine vergleichsweise hohe Sekundärelektronenausbeute (γ > 5; genauer Wert hängt von der Energie der Projektil-Ionen ab) aufweist (wie es bei einer Strahlquelle mit Kaltkathode und zugehöriger Plasma-Anode erforderlich ist), als auch eine niedrige Elektronenaustrittsarbeit (φ < 4 eV) und einen hohen Schmelzpunkt (Ts > 1750 K) besitzt (wie es bei einer Glühkathode vorteilhaft ist). Verfügbare Materialien, die diesen Kriterien genügen, sind beispielsweise in der Gruppe der Seltenerd-Boride zu finden. Bei einer Ausführungsform besteht der erste Teil der Kathode, der den zentralen Oberflächenbereich bildet, aus einer massiven, scheibenförmigen Lanthanhexaborid (LaB₆)- Tablette. Bei einer weiteren Ausführungsform besteht der erste Teil der Kathode aus einem Verbundkörper, der im Elektronen emittierenden Oberflächenbereich eine Schicht LaB₆, die mittels eines Hochtemperatur-Klebers oder -Lots auf einer temperaturbeständigen Trägerplatte befestigt wurde, umfasst. Alternativ kann die Schicht aus LaB₆ auch mittels anderer Verfahren, wie beispielsweise PVD-Verfahren, Sintern, Schweißen oder Pulver-Spritzverfahren auf der Trägerplatte abgeschieden sein.

Ein zweiter Teil der Kathode mit einem Oberflächenbereich, der den mittigen, ersten Oberflächenbereich umschließt, besteht aus einem zweiten Material. Das zweite Material weist eine hohe Temperaturbeständigkeit (Ts > 1750 K) und eine möglichst niedrige Wärmeleitfähigkeit auf und besitzt nur eine geringe Sekundärelektronenausbeute (γ < 5) bei hoher Austrittsarbeit (φ > 4 eV). Graphit ist hierfür beispielsweise besonders geeignet. Alternativ können dafür aber auch Materialien wie Refraktärmetalle, wie beispielsweise W, Ta, Mo, Ti, Legierungen dieser Materialien oder - für geringe Strahlleistungen - auch Edelstahl verwendet werden.

Bekannte Elektronenstrahlerzeuger mit Kaltkathode weisen üblicherweise eine Kühleinrichtung auf, mittels der einerseits die Kathode selbst gekühlt wird, damit deren Material (zum Beispiel Aluminium) nicht infolge des Energieeintrages durch den Ionenbeschuss schmilzt und andererseits werden mit solch einer Kühleinrichtung auch an die Kaltkathode angrenzende Bauteile gekühlt, damit diese nicht beschädigt werden.

Eine erfindungsgemäße Vorrichtung kann ebenfalls über eine Kühleinrichtung verfügen. Mit dieser wird jedoch nicht die Kathode gekühlt, denn erfindungsgemäß ist zumindest das Erhitzen des ersten Teils mit dem mittigen Oberflächenbereich der Kathode infolge des Ionenbeschusses erwünscht bzw. sogar erforderlich, wie nachfolgend noch erläutert wird. Weil bei einer erfindungsgemäßen Vorrichtung mittels einer Kühleinrichtung lediglich benachbarte Bauteile der Kathode gekühlt werden sollen, ist es vorteilhaft, die Kathode thermisch von benachbarten Bauteilen zu isolieren. Dies bezieht sich insbesondere auf Bauteile, die bezüglich des Elektronenstrahls hinter der Kathode angeordnet sind.

Zündet man bei einer erfindungsgemäßen Vorrichtung eine Glimmentladung, indem zwischen Kathode und Anode eine für einen Elektronenstrahlerzeuger übliche elektrische Hochspannung angelegt und ein Arbeitsgas durch den Einlass in die evakuierte Kathodenkammer geführt wird, geschieht Folgendes: Der aus dem ersten Material bestehende mittige, erste Bereich der zu Beginn kalten Kathode fungiert zunächst einmal nur als Sekundärelektronen-Emitter durch das Beaufschlagen mit beschleunigten Ionen. Unter dem fortwährenden Ionenbombardement und mangels Kühlung erwärmt sich dieser Bereich allerdings kontinuierlich, bis das erste Material schließlich eine Oberflächentemperatur erreicht, bei der zusätzlich auch noch thermionisch emittierte Elektronen infolge des glühelektrischen Effekts austreten und die Elektronenstromdichte des Elektronenstrahls erhöhen. Ab dieser Oberflächentemperatur wirken beide Emissionsmechanismen in Koexistenz, wobei der glühelektrische Effekt mit weiter ansteigender Oberflächentemperatur des ersten Materials eine zunehmende Dominanz erlangt. Mit einer erfindungsgemäßen Vorrichtung sind daher Elektronenstromdichten erzielbar, wie sie sonst nur von Elektronenstrahlerzeugern mit Glühkathode bekannt sind. Weil bei der Kathode einer erfindungsgemäßen Vorrichtung beide Emissionsmechanismen wirken, wird für eine solche Kathode an dieser Stelle der Begriff Hybridkathode eingeführt.

Bei beiden Emissionsmodi stammen die freien Elektronen bei einer Hybridkathode jedoch vorwiegend aus dem ersten Teil der Kathode, der aus dem ersten Material besteht. Dieser Teil der Kathode wird deshalb nachfolgend auch Emitter genannt. Die geringe Anzahl von Sekundärelektronen, die vom zweiten Material emittiert werden, ist hingegen für das Leistungsdichteprofil des Elektronenstrahls vernachlässigbar. Da die Elektronen des Elektronenstrahls im Wesentlichen nur vom Emitter herrühren, sind dessen Form und Größe auch ausschlaggebend für Form und Abmaße des Elektronenstrahlquerschnitts. Wie bereits dargelegt, macht die Oberfläche des Emitters nur einen Anteil der Kathodenoberfläche aus, weshalb bei Elektronenstrahlerzeugern mit einer Hybridkathode Elektronenstrahlen mit geringem Strahlquerschnitt erzeugbar sind, gegenüber Elektronenstrahlerzeugern mit Kaltkathode, bei der von der gesamten Oberfläche einer zugehörigen flächigen Kathode Elektronen emittiert und somit Elektronenstrahlen großen Querschnitts generiert werden.

Gewöhnlich weisen die Elektronen emittierenden Flächen bei Kaltkathoden-Axialstrahlern eine runde, konkav gewölbte Form auf, um einen Elektronstrahl mit rundem Querschnitt zu formen. Eine Hybridkathode ist ebenfalls vorzugsweise rund gestaltet. In diesem Fall ist das Material des Emitters als runde Scheibe und das zweite Material, welches den Emitter umschließt, ringförmig mit konkaver Wölbung ausgebildet. Der Emitter kann aber alternativ auch jede andere geometrische Form aufweisen.

Die Elektronen emittierende Oberfläche des Emitters kann planar, konvex oder konkav gewölbt ausgebildet sein, ferner kann sie fluchtend zur umgebenden Oberfläche des zweiten Materials oder gegenüber dessen Oberfläche um einen definierten Abstand entgegen oder in der Emissionsrichtung axial versetzt angeordnet sein. Zur Optimierung der thermischen Isolation des Emitters ist zumindest ein evakuierter Spalt zwischen der Rückseite der Kathode und den gekühlten benachbarten Bauteilen, besser noch ein rückseitig angeordneter, als thermisch floatender Mehrlagenreflektor ausgelegter Strahlungsschirm zweckmäßig.

Das zweite Material, welches den Emitter umschließt, hat neben einer Haltefunktion für das Emittermaterial im Wesentlichen drei Aufgaben zu erfüllen.

Erstens wird mit dem zweiten Material die Oberfläche der Kathode vergrößert. Soll nämlich ein Elektronenstrahl mit geringem Strahldurchmesser erzeugt werden und ist demzufolge die Elektronen emittierende Fläche des Emitters sehr klein, dann kann die alleinige Fläche des Emitters zu klein sein, um eine stabile Glimmentladung zwischen Emitter und Anode aufrechtzuerhalten. Das zweite Material muss aus diesem Grund ebenfalls elektrisch leitfähig sein und weist das gleiche elektrische Potential auf wie der Emitter, um die Kathodenfläche zu vergrößern. Bei einer Ausführungsform ist daher die dem Ionenbeschuss ausgesetzte Fläche des zweiten Materials mindestens dreimal so groß wie die des Emitters.

Zweitens wurde zuvor bereits die Thematik der thermischen Isolation der Kathode gegenüber benachbarten Bauteilen dargelegt. Das zweite Material, welches das Emittermaterial umschließt, bildet hierbei eine erste Stufe der thermischen Isolation des aufgrund des Ionenbeschusses sehr heiß werdenden Emitters gegenüber benachbarten Baugruppen. Das zweite Material, welches sowohl infolge des Ionenbeschusses als auch durch Wärmeleitung vom Emitter herrührend erhitzt wird, sollte deshalb eine schlechte Wärmeleitfähigkeit aufweisen. Der Emitter kann auch vom umschließenden zweiten Material mit einem Spalt beabstandet sein, um eine Wärmebarriere auszubilden. Dieser Spalt wirkt dann gleichzeitig als Dehnungsfuge für das sich erhitzende und sich dadurch ausdehnende Emittermaterial. Dabei ist der Spalt vorzugsweise derart zu dimensionieren, dass dieser auch bei maximal erhitztem Emittermaterial nicht vollständig durch das sich ausdehnende Emittermaterial geschlossen wird. Durch eine geeignete Kontaktierung (z. B. mittels eines Sprengringes) ist aber immer sicherzustellen, dass der Emitter und das zweite Material das gleiche elektrische Potential aufweisen und dass der Stromtransport zum Emitter gewährleistet bleibt.

Drittens lässt sich durch Variation der geometrischen Form des zweiten Materials Einfluss auf die elektrostatische Strahlformierung nehmen. Die Oberfläche des zweiten Materials ist zur Erzeugung eines axialen Elektronenstrahls vorzugsweise sphärisch-konkav oder kegelförmig gewölbt und formt somit einen (quasi-) sphärischen Verlauf der elektrischen Äquipotentialflächen im Bereich der Strahlerachse, was dann zur radial-konvergenten Beschleunigung der Elektronen führt. Derartige homozentrische Elektronenstrahlen lassen sich elektronenoptisch besonders gut führen und mit hoher Leistungsdichte zum Prozessort projizieren. Die Oberflächenkontur des zweiten Materials wird insbesondere so gewählt, dass der Durchmesser des Elektronenstrahls im Bereich der Austrittsöffnung aus dem Gehäuse der Kathodenkammer möglichst klein ist. Unter diesen Bedingungen kann auch der Querschnitt der Austrittsöffnung klein gehalten werden, was es ermöglicht, die Glimmentladung in der Kathodenkammer bei relativ geringem Arbeitsgasverbrauch aufrechtzuerhalten.

Ein erfindungsgemäßer Elektronenstrahlerzeuger ist während seines Einsatzes vorzugsweise an eine Wandung einer Vakuumprozesskammer angeflanscht, so dass sich deren Vakuum durch die Strahlaustrittsöffnung bis in das Innere der Kathodenkammer erstreckt. Der Elektronenstrahlerzeuger braucht somit selber keine eigene Vakuumpumpe, um die Kathodenkammer zu evakuieren, sondern dies erfolgt dann mittels der Vakuumpumpe(n) der Vakuumkammer, sofern der Prozessdruck in der Vakuumkammer niedriger als der Arbeitsdruck der Glimmentladung in der Kathodenkammer gewählt werden kann.

Stellgröße für die Emissionsstromregelung einer Hybridkathode ist - so wie bei einer Kalt-kathode - die Flussmenge des Plasma-Arbeitsgases. Im Unterschied zur Kaltkathode wird die Elektronenemission allerdings nicht nur direkt über die Ionenstromdichte und die davon unmittelbar abhängige Generierung von Sekundärelektronen, sondern auch mittelbar über die Regulierung der Temperatur der Emissionsfläche und die davon abhängige Freisetzung thermionischer Elektronen gesteuert.

Die Erfindung ermöglicht das Realisieren eines Elektronenstrahlerzeugers vom Axialtyp, der die Vorzüge konventioneller Elektronenstrahler mit Glühkathode (hohe Emissionsstrom- und Strahlleistungs-Dichte, hohe Beschleunigungsspannungen, keine Reaktivgasbelastung der Prozesskammer, Kühlkreisläufe auf Erdpotential) und die von Kaltkathodenstrahlern mit Plasma-Anode (preiswerter und kompakter Aufbau, kein eigenes Vakuumsystem, vereinfachte Hochspannungsversorgung, Leistungsregelung auf Erdpotential) in sich vereinigt.

Da der Durchmesser des Emitters vergleichsweise klein ist, können mittels einer Hybridkathode bei gleichem Strom und vergleichbar simplem Aufbau wesentlich schlankere Elektronenstrahlen (mit größerer Leistungsdichte) als mit einer kalten Aluminium-Großflächenkathode erzeugt und am Prozessort (z. B. an einem Verdampfertiegel) effizienter als bisher zur Wirkung gebracht werden. Experimentell wurde aus einer Hybridkathode mit einem LaB₆ -Emitter mit 17 mm Durchmesser und einem zugehörigen Graphitring von 90 mm Außendurchmesser ein Strom von > 3 A bei 25 kV Beschleunigungsspannung extrahiert. Zum Vergleich: Die bisher verwendete massive Aluminium-Kaltkathode mit 90 mm Durchmesser liefert diesen Strom bei etwa fünffach höherem Strahldurchmesser.

Nach der bisherigen Analyse des Hybridkathoden-Konzeptes basierend auf einem gasentladungsgeheizten LaB₆-Emitter ist bei einer erfindungsgemäßen Vorrichtung (im Gegensatz zu Vorrichtungen mit Kaltkathode) das Verwenden eines inerten Plasma-Arbeitsgases wie beispielsweise aller Edelgase in der Kathodenkammer möglich. Eine Beimischung reaktiver Gase ist prinzipiell möglich, kann jedoch zu einer sogenannten "chemischen Kathodenvergiftung" führen, weil beispielsweise Sauerstoff und Wasserdampf die Austrittsarbeit bei einem LaB₆-Emitter heraufsetzen. Leichte Arbeitsgase sind wegen der damit reduzierten Sputtererosion der Emissionsfläche ("physikalische Kathodenvergiftung") und einer geringeren Streuung der Elektronen zu favorisieren. Unter Berücksichtigung ökonomischer Randbedingungen bieten sich zum Beispiel technisch reines Helium oder auch Wasserstoff als technisch adäquate und gleichzeitig kostengünstige Lösungen an.

Die Leistungsregelung der Hybridkathode erfolgt, wie schon erwähnt, mittels Variation des Arbeitsgasflusses in die Kathodenkammer. Diese wirkt im glühelektrischen Emissionsmode zwar nur mittelbar über die Regulierung der Temperatur der Emissionsfläche, verglichen mit der für konventionelle Hochleistungsstrahler üblichen Stoßheizung des Kathodenblockes von der Rückseite her sind aber immer noch dynamische Vorteile vorhanden, da sich die thermische Trägheit des Kathodenkörpers bei einer Heizung von der Emissionsseite her - wie sie durch den Ionenbeschuss bewirkt wird - weniger stark manifestiert.

Experimente haben gezeigt, dass der kombinierte Emissionsmechanismus der Hybridkathode gegenüber den bekannten Kaltkathoden auch mit einem (bei gleichem Strom) verringerten Arbeitsgasdruck in der Kathodenkammer und der dazu positiv korrelierten Verlustleistung einhergeht. Das führt zu drei Vorteilen: Erstens, die aus der Kathodenkammer in eine Prozesskammer überströmende Gasmenge wird reduziert mit günstigen Auswirkungen auf den dort erzielbaren Arbeitsdruck bzw. mit somit verringerten Anforderungen an die Dimensionierung des Vakuumsystems. Zweitens, eine direkte Wasserkühlung der Kathode wird entbehrlich (womit komplizierte, hochspannungsfest isolierte Kühlwasserschläuche entfallen und der Kühlkreis beim Kathodenwechsel nicht mehr geöffnet werden muss). Drittens, die erforderliche Dunkelfeldschirmung der Kathodenhalterung gestaltet sich einfacher, und auch höhere Beschleunigungsspannungen (z. B. im Bereich 40 bis 60 kV) können mit geringem Aufwand appliziert werden.

Der Vollständigkeit halber sei an dieser Stelle erwähnt, dass bei einer erfindungsgemäßen Vorrichtung ebenso, wie aus dem Stand der Technik bekannt, verschiedene Lösungen für die Realisierung einer Anode zur Anwendung gelangen können. Im einfachsten Fall kann das Gehäuse der Kathodenkammer elektrisch als Anode geschaltet werden. Es ist aber auch möglich, eine separate Anode in der Kathodenkammer anzuordnen, die elektrisch vom geerdeten Gehäuse isoliert ist und somit auch ein anderes Potential führen kann. Eine derartige separate Elektrode kann beispielsweise ringförmig ausgebildet sein, wobei die Ringöffnung als Elektronenstrahlaustrittsöffnung fungiert.

### Ausführungsbeispiel

Die Erfindung wird nachfolgend anhand von Ausführungsbeispielen näher erläutert. Die Fig. zeigen:
- Fig. 1: eine schematische Darstellung einer erfindungsgemäßen Vorrichtung zum Erzeugen eines Elektronenstrahls;
- Fig. 2: eine schematische Darstellung des Kathodenkopfes einer Elektronenstrahlquelle mit stoßgeheizter, thermionischer Blockkathode;
- Fig. 3: eine schematische Darstellung des Kathodenkopfes einer Elektronenstrahlquelle mit direkt gekühlter, glimmentladungsstimulierter Kaltkathode;
- Fig. 4: eine schematische Darstellung des Kathodenkopfes einer erfindungsgemäßen Vorrichtung in einer Ausführungsform mit direkt gekühlter Montagebasis;
- Fig. 5: eine schematische Darstellung des Kathodenkopfes einer erfindungsgemäßen Vorrichtung in einer Ausführungsform mit indirekt gekühlter Montagebasis und thermisch floatendem Strahlungsschirm;

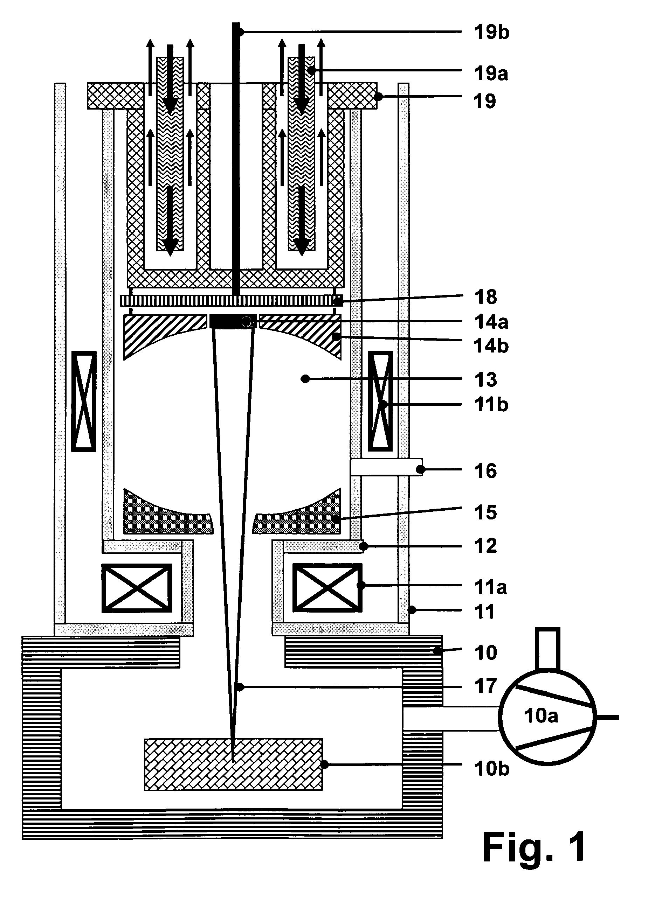

Graphische Elemente innerhalb einer Figur mit gleicher flächenfüllender Strukturierung bilden ein Bauteil. In Fig. 1 ist eine erfindungsgemäße Vorrichtung schematisch dargestellt. An einer Vakuumkammer 10 ist ein Elektronenstrahlerzeuger 11 befestigt, der ein Gehäuse 12 umfasst. Das Gehäuse 12 begrenzt an der Strahlaustrittsseite einen als Kathodenkammer ausgebildeten evakuierbaren Raum 13. In der Kathodenkammer 13 ist eine aus zwei Materialien bestehende, runde, flächige Kathode 14 angeordnet. Ein scheibenförmig und planar ausgebildeter Emitter 14a aus LaB₆ mit einem Scheibendurchmesser von 17 mm fungiert als zentraler Bereich der Kathode 14. Der Emitter 14a ist von einem Graphitring 14b mit einem Außendurchmesser von 90 mm umgeben, von diesem jedoch durch einen umlaufenden Spalt mechanisch getrennt. Dennoch weisen sowohl der Graphitring 14b als auch die Emitterscheibe 14a mittels in Fig. 1 nicht dargestellter Kontaktierungselemente das gleiche elektrische (Kathoden-)Potential auf. Der Kathode 14 gegenüberliegend angeordnet ist eine Anode 15, die als ringförmige Scheibe ausgebildet ist und deren axiale Ringöffnung als Elektronenstrahlaustrittsöffnung in die Vakuumkammer 10 fungiert. Vakuumpumpen 10a der Vakuumkammer 10 evakuieren sowohl die Vakuumkammer 10 selbst als auch die Kathodenkammer 13, in welche sich das Vakuum der Vakuumkammer 10 durch die Ringöffnung der Anode 15 hindurch erstreckt.

Zum Zünden einer Glimmentladung zwischen der Kathode 14 und der Anode 15 wird durch einen Gaseinlass 16 Helium in die evakuierte Kathodenkammer 13 eingelassen und gleichzeitig eine bei Elektronenstrahlerzeugern typische elektrische Hochspannung von -30 kV geschaltet, die als Brennspannung zwischen Kathode 14 und Anode 15 fungiert, wobei die vom Gehäuse 12 mechanisch getrennte Anode 15 wahlweise auf Erdpotential oder ein davon verschiedenes elektrisches Potential gelegt werden kann. Je nach technologischem Einsatzzweck des Elektronenstrahlerzeugers 11 kann es ferner zweckmäßig sein, die Hochspannung nicht als Gleichspannung, sondern in Form schnell aufeinander folgender Spannungspulse anzulegen. Daraufhin bildet sich zwischen Kathode 14 und Anode 15 ein Glimmentladungsplasma aus, dessen Ionen auf die Oberfläche der Kathode 14 beschleunigt werden, woraufhin vornehmlich aus dem Material des Emitters 14a Sekundärelektronen emittiert werden. Aufgrund der relativ geringen Elektronen emittierenden Oberfläche des Emitters 14a und der konkaven Form des Graphitrings 14b werden die emittierten Elektronen zu einem schlanken Elektronenstrahl 17 gebündelt.

Infolge des fortwährenden Ionenbeschusses der nicht gekühlten Emitteroberfläche wird diese bis zu einer Temperatur erhitzt, ab der zusätzlich zu den Sekundärelektronen auch noch Elektronen aufgrund thermischer Emission vom Emittermaterial emittiert werden, welche die Leistungsdichte des Elektronenstrahls 17 erhöhen. Auf diese Weise entsteht ein Elektronenstrahl mit geringem Strahlquerschnitt und sehr hoher Leistungsdichte, der durch die Elektronenstrahlaustrittsöffnung der Anode 15 aus der Kathodenkammer 13 ausgekoppelt, dann mittels bekannter elektronenoptischer Baugruppen 11a (Linsenbaugruppen und Ablenkspulen) des Elektronenstrahlerzeugers 11 zu einem in der Vakuumkammer 10 angeordneten Target 10b geführt und dort wie von der beabsichtigten Bearbeitungsaufgabe (z. B. Erwärmen, Schmelzen oder Verdampfen von Material) definiert zur Einwirkung gebracht werden kann.

Außerhalb der Kathodenkammer 13, etwa auf halber Distanz zwischen Kathode 14 und Anode 15, ist ein zusätzliches Magnetspulensystem 11 b angeordnet, das aus zwei gekreuzten Sattelspulenpaaren besteht. Damit ist es möglich, in der Kathodenkammer 13 ein Magnetfeld variabler Feldstärke mit zur Strahlerachse senkrechtem, aber azimutal frei ausrichtbarem Feldlinienverlauf zu erzeugen. Im Unterschied zu bekannten Magnetspulensystemen für axiale Entladungsanordnungen, bei denen mitunter ein axiales Magnetfeld zur Plasmaverdichtung oder zur Stabilisierung der Entladung eingesetzt wird, dient das hier beschriebene Magnetspulensystem 11 b der Erzeugung eines transversal zur Elektronenstrahlachse verlaufenden Magnetfeldes, mit dem die Ausbreitungsrichtung des Elektronenstrahls 17 beeinflusst werden kann. Damit ist es möglich, den Elektronenstrahl 17 auch unter dem Einfluss äußerer Störfelder oder trotz leichter Fehljustagen der Kathode 14 stets präzise auf die Elektronenstrahlaustrittsöffnung der Anode 15 zu zentrieren. Im Unterschied zu bekannten Strahlersystemen, bei denen die Zentriereinheit Teil der elektronenoptischen Säule unterhalb der Anode ist, wirkt das hier beschriebene Magnetspulensystem 11 b bereits in der Kathodenkammer 13, d. h. schon während der Beschleunigung der Elektronen, und damit besonders effektiv. Mit diesem Hilfsmittel lässt sich der Durchmesser der Elektronenstrahlaustrittsöffnung besonders eng (≤ 20% des Kathodendurchmessers) tolerieren und der Verbrauch an Plasma-Arbeitsgas somit weiter reduzieren. Das Magnetspulensystem 11b ist hier zwar anhand eines konkreten Ausführungsbeispiels beschrieben, kann jedoch auch bei allen anderen Ausführungsformen von erfindungsgemäßen Vorrichtungen eingesetzt werden, indem dieses außerhalb der Kathodenkammer auf einer Höhe zwischen Hybridkathode und zugehöriger Anode angeordnet wird.

Die hohen Temperaturen, auf die der Emitter 14a infolge des Ionenbeschusses erhitzt wird, erfordern einen thermischen Schutz für benachbarte Bauelemente. Zu diesem Zweck ist auf der Rückseite der Kathode 14 ein thermischer Isolator 18 angeordnet, der wiederum an einem elektrischen Isolator 19 befestigt ist. Letzterer fungiert gleichzeitig als Wandung für die Kathodenkammer 13 und umfasst auch Kühlkanäle 19a sowie eine vakuumdichte Hochspannungszuführung 19b in die Kathodenkammer 13. Die Kühlkanäle 19a sind röhrenförmig ausgebildet. Ein Kühlmedium fließt innerhalb dieser Röhren nach unten, was durch die dickeren und nach unten gerichteten Pfeile veranschaulicht wird und in Zwischenräumen, die sich zwischen den Röhren und den elektrischen Isolator 19 erstrecken, wieder nach oben, was durch die dünneren und nach oben gerichteten Pfeile veranschaulicht wird. Zum Zwecke der verbesserten thermischen Isolation des Emitters 14a ist dieser sowohl vom thermischen Isolator 18 als auch vom Graphitring 14b mit einem Spalt beabstandet.

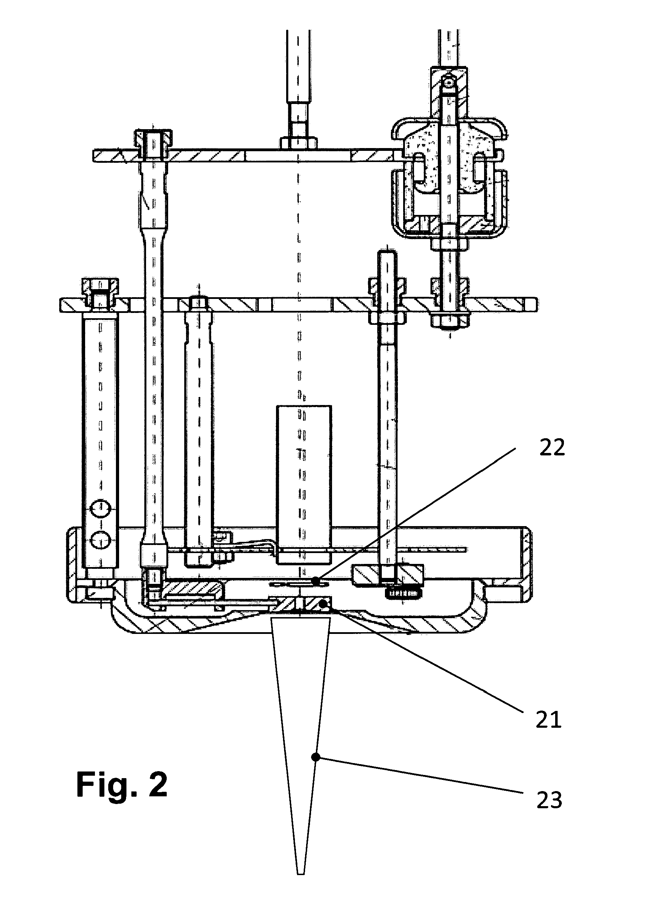

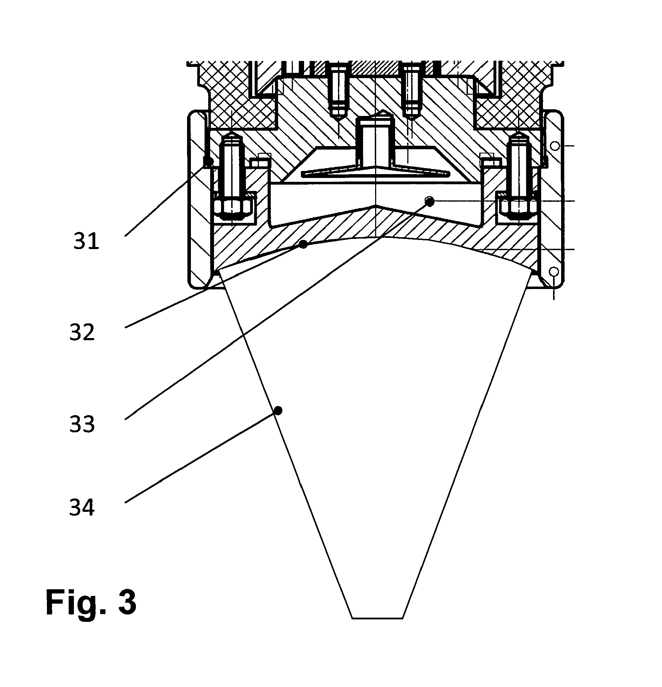

Zum Vergleich mit dem Stand der Technik sind in Fig. 2 ein bekannter Kathodenstecker mit Wolfram-Glühkathode und in Fig. 3 ein ebenfalls bekannter Kathodenkopf mit Aluminium-Kaltkathode schematisch dargestellt.

Der Kathodenstecker aus Fig. 2 umfasst neben der Glühkathode 21 aus Wolfram noch eine Heizwendel 22, mittels derer die Kathode 21 von der Rückseite her durch Elektronenstoß aufgeheizt wird, so dass beim Erreichen einer entsprechenden Temperatur an der Vorderseite der Kathode 21 Elektronen aufgrund des thermoelektrischen Effekts emittiert werden. Aufgrund des relativ geringen Querschnitts der Kathode 21 entsteht bei einer derartigen Vorrichtung ein Elektronenstrahl 23 mit geringem Strahlquerschnitt. Einem solchen Kathodenstecker müssen jedoch drei elektrische Potenziale zugeführt werden, zwei elektrische Potenziale für die Glühwendel und das Kathodenpotenzial. Die hohe Betriebstemperatur der Wolfram-Glühkathode sowie die Notwendigkeit der Führung und gegenseitigen elektrischen Isolation mehrerer Potentiale auf beschränktem Raum bedingen einen vergleichsweise komplizierten mechanischen Aufbau des Kathodensteckers, woraus die aufwändige Fertigung sowie hohe Anforderungen an die Montage und Justage resultieren.

Der Kathodenkopf aus Fig. 3 umfasst eine Montagebasis 31, an welcher eine scheibenförmige Kaltkathode 32 aus Aluminium mit einem Außendurchmesser von 90 mm mittels Schraubverbindungen befestigt ist, wobei diese beiden Elemente einen Hohlraum 33 einschließen, der von einem Kühlmedium durchströmt wird. Das Kühlmedium strömt somit direkt an der Rückseite der Kathode 32 vorbei und kühlt diese. Zwischen der Kathode 32 und einer in Fig. 3 nicht dargestellten Anode ist ein Glimmplasma erzeugbar, aus dem heraus Ionen auf die Oberfläche der Kathode 32 beschleunigt werden, wodurch Sekundärelektronen aus dem Kathodenmaterial heraustreten. Weil diese Sekundärelektronen von der gesamten Oberfläche der Kathode 32 emittiert werden und keine sonstigen Emissionsmechanismen wirken, die weitere Elektronen freisetzen könnten, entsteht ein Elektronenstrahl 44 mit relativ großem Strahlquerschnitt und geringer Leistungsdichte im Verhältnis zu den Elektronenstrahlen 17 und 23 aus Fig. 1 und Fig. 2. Im Vergleich zum aufwändigen Kathodenkopf für die Wolfram-Glühkathode aus Fig. 2 ist der Kathodenkopf der Kaltkathode allerdings konstruktiv einfacher gestaltet und wartungsfreundlicher.

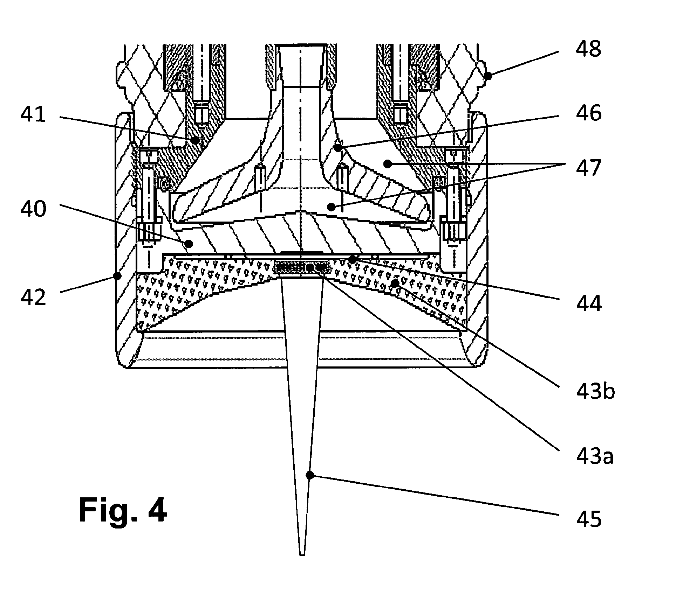

In Fig. 4 ist der Kathodenkopf einer erfindungsgemäßen Vorrichtung in einer ersten Ausführungsvariante etwas detaillierter schematisch dargestellt. Der Kathodenkopf umfasst eine Montagebasis 40 aus Aluminium und eine Montagebasis 41 aus Edelstahl, die mittels Schraubverbindungen aneinander gepresst sind. Mittels einer Überwurfmutter 42 wird ein Graphitring 43b mit einem Außendurchmesser von 90 mm an die Montagebasis 20 gedrückt. Dabei ist der Graphitring 43b, in dessen Ringöffnung eine ebene LaB₆-Emitter-Scheibe 43a mit 17 mm Außendurchmesser eingefügt ist, derart ausgebildet, dass der Graphitring 43b zum Zwecke der thermischen Isolation großflächig mit einem Spalt 44 von der Montagebasis 40 beabstandet ist. Der Emitter 43a und der Graphitring 43b bilden gemeinsam eine Hybridkathode 43, bei der hauptsächlich vom Emitter 43a Elektronen für einen Elektronenstrahl 45 emittiert werden. Auf der anderen Seite der Montagebasis 40 ist ein Formteil 46 angeordnet, welches somit Hohlräume 47 zur Montagebasis 40 und 41 hin ausbildet. Diese Hohlräume 47 sind von einem Kühlmittel durchflossen, wobei das Formteil 46 eine gerichtete Anströmung und intensive Kühlung der Montagebasis 40 sicherstellt. Der Kathodenkopf umfasst ebenfalls einen Isolatorkörper 48 aus Kunststoff, welcher hinter dem Kathodenkopf angeordnete Bauteile elektrisch vom Kathodenpotential isoliert. Mit dieser ersten Ausführungsvariante der erfindungsgemäßen Vorrichtung kann bei vergleichsweise einfacher konstruktiver Gestaltung und Nutzung preisgünstiger Materialien zum Aufbau des Kathodenkopfes bereits ein Elektronenstrahl 45 erzeugt werden, der hinsichtlich seines Durchmessers und seiner Leistungsdichte dem der Wolfram-Glühkathode aus Fig. 2 entspricht. Vorteilhaft ist ferner, dass der Kühlkreislauf bei einem Wechsel der Hybridkathode 43 nicht mehr geöffnet werden muss, wie das bei der Kaltkathode nach Fig. 3 erforderlich ist. Nachteilig ist allerdings auch in der bisher beschriebenen Ausführungsvariante der Erfindung, dass noch ein direkter elektrischer Kontakt des Kühlmediums zum Kathodenpotential besteht, was erhöhten Aufwand bei der Sicherheitsisolation des Kühlkreislaufes für den Kathodenkopf verursacht.

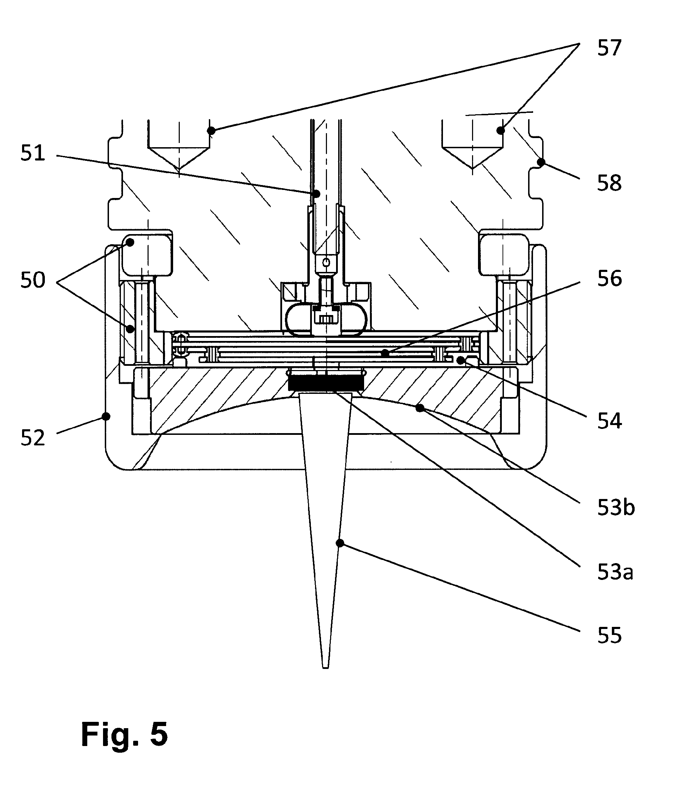

In Fig. 5 ist der Kathodenkopf einer erfindungsgemäßen Vorrichtung in einer zweiten, weiter verbesserten Ausführungsvariante schematisch dargestellt. Der Kathodenkopf umfasst wiederum eine aus zwei Teilen gebildete Montagebasis 50, hier allerdings aus Molybdän bestehend, die mittels Schraubverbindungen aneinander und an einen elektrischen Isolatorkörper 58, hier aus Aluminiumnitrid bestehend, gepresst sind. Alternativ könnte der Isolatorkörper 58 auch aus einer Oxydkeramik bestehen. Mittels einer Überwurfmutter 52 wird ein Graphitring 53b (Außendurchmesser 90 mm), in dessen Ringöffnung eine ebene LaB₆-Emitter-Scheibe 53a (Außendurchmesser 17 mm) eingefügt ist, an die Montagebasis 50 gedrückt. Der Emitter 53a und der Graphitring 53b bilden gemeinsam eine Hybridkathode 53, bei der hauptsächlich vom Emitter 53a Elektronen für einen Elektronenstrahl 55 emittiert werden. Dabei ist die Montagebasis 50 derart ausgebildet, dass zwischen der Hybridkathode 53 und dem Isolatorkörper 58 großflächig ein evakuierter Zwischenraum 54 von 10 mm Höhe entsteht, in den ein thermisch floatender, mehrlagiger Strahlungsschirm 56 eingebaut ist, der von drei untereinander vernieteten, durch Abstandshalter separierten, parallelen Edelstahlblechscheiben gebildet wird. Wegen der (im Vergleich zum Wärmeisolationsvermögen eines einzelnen Zwischenraums, wie mittels Spalt 44 von Fig. 4 realisiert) dadurch verbesserten thermischen Isolation der Hybridkathode 53 muss die Montagebasis 50 nicht mehr direkt von einem Kühlmittel umflossen werden. Die Hohlräume 57 zur Führung eines Kühlmittels sind vielmehr nun in den elektrischen Isolatorkörper 58 integriert, wodurch die angestrebte Separation von Kühlmittel und Kathodenpotential erreicht wird. Ebenfalls durch den Isolatorkörper 58 führt eine vakuumdichte Hochspannungszuführung 51 durch welche die für den Betrieb des zugehörigen Elektronenstrahlers erforderliche Hochspannung an den mehrlagigen Strahlungsschirm 56 und über diesen an die Kathode 53 geführt wird.

## Patentansprüche

1. Vorrichtung zum Erzeugen eines Elektronenstrahls, umfassend ein Gehäuse (12), welches einen evakuierbaren Raum (13) begrenzt und eine Elektronenstrahlaustrittsöffnung aufweist; einen Einlass (16) für das Zuführen eines Arbeitsgases in den evakuierbaren Raum (13); eine flächige Kathode (14) und eine Anode (15), die im evakuierbaren Raum (13) angeordnet sind und zwischen denen mittels einer angelegten elektrischen Spannung ein Glimmentladungsplasma erzeugbar ist, wobei Ionen aus dem Glimmentladungsplasma auf die Oberfläche der Kathode (14) und von der Kathode emittierte Elektronen in das Glimmentladungsplasma hinein beschleunigbar sind, wobei
a) ein erster Teil (14a) der Kathode (14), welcher einen zentral angeordneten ersten Oberflächenbereich der Kathode (14) ausbildet, zumindest emissionsseitig aus einem ersten Material besteht;
b) ein zweiter Teil (14b) der Kathode (14), der einen zweiten Oberflächenbereich der Kathode (14) ausbildet, welcher den ersten Oberflächenbereich umschließt, aus einem zweiten Material besteht;
c) das erste Material elektrisch leitfähig ist, eine Schmelztemperatur Tₛ größer als 1750 K aufweist und eine Elektronenaustrittsarbeit kleiner 4 eV besitzt;
d) das zweite Material elektrisch leitfähig ist, eine Schmelztemperatur Tₛ größer als 1750 K aufweist und eine Elektronenaustrittsarbeit größer 4 eV besitzt;
e) das erste Material durch das Beaufschlagen mit beschleunigten Ionen auf eine Temperatur erhitzbar ist, bei der Elektronen überwiegend durch Glühemission aus dem ersten Material heraustreten und die Vorrichtung keine Einrichtung zum Kühlen der Kathode (14) aufweist.

2. Vorrichtung nach Anspruch 1, **dadurch gekennzeichnet, dass** der erste Oberflächenbereich eben ausgebildet ist.

3. Vorrichtung nach Anspruch 1, **dadurch gekennzeichnet, dass** der erste Oberflächenbereich konkav ausgebildet ist.

4. Vorrichtung nach einem der vorhergehenden Ansprüche, **dadurch gekennzeichnet, dass** der den ersten Bereich umschließende zweite Oberflächenbereich konkav ausgebildet ist.

5. Vorrichtung nach einem der vorhergehenden Ansprüche, **dadurch gekennzeichnet, dass** das erste Material ein Seltenerd-Borid umfasst.

6. Vorrichtung nach einem der Ansprüche 1 bis 5, **dadurch gekennzeichnet, dass** der erste Oberflächenbereich durch einen massiven, aus dem ersten Material bestehenden Formkörper (14a) gebildet ist.

7. Vorrichtung nach einem der Ansprüche 1 bis 5, **dadurch gekennzeichnet, dass** der erste Oberflächenbereich Bestandteil eines Verbundkörpers ist.

8. Vorrichtung nach einem der vorhergehenden Ansprüche, **dadurch gekennzeichnet, dass** das zweite Material Graphit umfasst.

9. Vorrichtung nach einem der vorhergehenden Ansprüche, **dadurch gekennzeichnet, dass** das zweite Material ein Metall umfasst.

10. Vorrichtung nach einem der vorhergehenden Ansprüche, **dadurch gekennzeichnet, dass** der erste und der zweite Oberflächenbereich durch einen um den ersten Oberflächenbereich umlaufenden Spalt getrennt sind.

11. Vorrichtung nach einem der vorhergehenden Ansprüche, **dadurch gekennzeichnet, dass** zumindest das erste Material durch eine rückseitige Wärmebarriere von gekühlten Teilen der Vorrichtung thermisch isoliert ist.

12. Vorrichtung nach Anspruch 11, **dadurch gekennzeichnet, dass** die Wärmebarriere zumindest einen evakuierbaren Spalt (44; 54) oder/und einen thermischen Isolator (18; 56) umfasst.

13. Vorrichtung nach einem der Ansprüche 1 bis 11, **dadurch gekennzeichnet, dass** das Arbeitsgas der Glimmentladung ein Edelgas oder Wasserstoff ist.

14. Vorrichtung nach einem der vorhergehenden Ansprüche, **dadurch gekennzeichnet, dass** deren Strahlleistung bei konstanter oder gepulster Brennspannung mittels Variation des Arbeitsgasflusses der Glimmentladung regelbar ist.

15. Vorrichtung nach einem der vorhergehenden Ansprüche, **gekennzeichnet durch** einen elektrischen Isolatorkörper (19; 48; 58) welcher vom Kathodenpotential getrennte Kühlkanäle (19a) und eine vakuumdichte Hochspannungsdurchführung (19b) aufweist.

16. Vorrichtung nach einem der vorhergehenden Ansprüche, **dadurch gekennzeichnet, dass** die Ausbreitungsrichtung des Elektronenstrahls (17) in der Kathodenkammer (13) durch ein mittels eines Magnetspulensystems (11 b) im Bereich zwischen Kathode (14) und Anode (15) erzeugtes, transversales Magnetfeld steuerbar ist.

17. Vorrichtung nach Anspruch 15, **dadurch gekennzeichnet, dass** der Isolatorkörper aus einem Kunststoff (48), aus einer Oxydkeramik oder aus Aluminiumnitrid (58) besteht.

## Claims

1. Device for producing an electron beam, comprising a housing (12), which bounds a space (13) that can be evacuated and has an electron beam outlet opening; an inlet (16) for feeding a working gas into the space (13) that can be evacuated; a planar cathode (14) and an anode (15), which are arranged in the space (13) that can be evacuated and between which a glow-discharge plasma can be produced by means of an applied electrical voltage, wherein ions can be accelerated from the glow-discharge plasma onto the surface of the cathode (14) and electrons emitted by the cathode can be accelerated into the glow-discharge plasma, wherein
a) a first part (14a) of the cathode (14), which forms a centrally arranged first surface region of the cathode (14), consists of a first material, at least on the emission side;
b) a second part (14b) of the cathode (14), which forms a second surface region of the cathode (14) that encloses the first surface region, consists of a second material;
c) the first material is electrically conductive, has a melting temperature T_{S} greater than 1750 K and has an electron work function less than 4 eV;
d) the second material is electrically conductive, has a melting temperature T_{S} greater than 1750 K and has an electron work function greater than 4 eV;
e) the first material can be heated by the impingement with accelerated ions to a temperature at which electrons escape from the first material predominantly due to thermionic emission and
the device has no means for cooling the cathode (14).

2. Device according to Claim 1, **characterized in that** the first surface region is designed to be flat.

3. Device according to Claim 1, **characterized in that** the first surface region is designed to be concave.

4. Device according to one of the preceding claims, **characterized in that** the second surface region, enclosing the first region, is designed to be concave.

5. Device according to one of the preceding claims, **characterized in that** the first material comprises a rare earth boride.

6. Device according to one of Claims 1 to 5, **characterized in that** the first surface region is formed by a solid moulded body (14a) consisting of the first material.

7. Device according to one of Claims 1 to 5, **characterized in that** the first surface region is a constituent of a composite body.

8. Device according to one of the preceding claims, **characterized in that** the second material comprises graphite.

9. Device according to one of the preceding claims, **characterized in that** the second material comprises a metal.

10. Device according to one of the preceding claims, **characterized in that** the first and the second surface regions are separated by a peripheral gap around the first surface region.

11. Device according to one of the preceding claims, **characterized in that** at least the first material is thermally insulated by a rear-side thermal barrier of cooled parts of the device.

12. Device according to Claim 11, **characterized in that** the thermal barrier comprises at least one gap (44; 54) that can be evacuated and/or a thermal insulator (18; 56).

13. Device according to one of Claims 1 to 11, **characterized in that** the working gas of the glow discharge is an inert gas or hydrogen.

14. Device according to one of the preceding claims, **characterized in that** the beam power thereof can be controlled in the case of a constant or pulsed operating voltage by means of varying the working gas flow of the glow discharge.

15. Device according to one of the preceding claims, **characterized by** an electrical insulator body (19; 48; 58), which has cooling channels (19a) separated from the cathode potential and a vacuum-tight high-voltage lead-through (19b).

16. Device according to one of the preceding claims, **characterized in that** the propagation direction of the electron beam (17) in the cathode chamber (13) can be controlled by a transverse magnetic field produced by means of a magnetic coil system (11b) in the region between the cathode (14) and anode (15).

17. Device according to Claim 15, **characterized in that** the insulator body consists of a plastic (48), of an oxide ceramic or of aluminium nitride (58).

## Revendications

1. Dispositif pour générer un rayon électronique, comprenant un boîtier (12) qui délimite un espace (13) pouvant être mis sous vide et présentant une ouverture de sortie du rayon électronique ; une entrée (16) pour l'introduction d'un gaz de travail dans l'espace (13) pouvant être mis sous vide ; une cathode (14) plate et une anode (15) qui sont disposées dans l'espace (13) pouvant être mis sous vide et entre lesquelles un plasma par décharge luminescente peut être généré au moyen d'une tension électrique appliquée, les ions du plasma par décharge luminescente étant accélérés sur la surface de la cathode (14) et les électrons émis par la cathode étant accélérés dans le plasma par décharge luminescente
a) une première partie (14a) de la cathode (14), qui forme une première zone de surface disposée de manière centrale de la cathode (14), étant constituée au moins côté émission par un premier matériau ;
b) une deuxième partie (14b) de la cathode (14), qui forme une deuxième zone de surface de la cathode (14), qui entoure la première zone de surface, étant constituée par un deuxième matériau ;
c) le premier matériau étant électriquement conducteur, présentant une température de fusion Tₛ supérieure à 1750 K et possédant un travail de sortie d'électrons inférieur à 4 eV ;
d) le deuxième matériau étant électriquement conducteur, présentant une température de fusion Tₛ supérieure à 1750 K et possédant un travail de sortie d'électrons supérieur à 4 eV ;
e) le premier matériau pouvant être chauffé par sollicitation par des ions accélérés à une température à laquelle les électrons sortent principalement par émission thermoélectronique du premier matériau et le dispositif ne présentant pas de dispositif pour le refroidissement de la cathode (14).

2. Dispositif selon la revendication 1, **caractérisé en ce que** la première zone de surface est réalisée de manière plane.

3. Dispositif selon la revendication 1, **caractérisé en ce que** la première zone de surface est réalisée de manière concave.

4. Dispositif selon l'une quelconque des revendications précédentes, **caractérisé en ce que** la deuxième zone de surface entourant la première zone est réalisée de manière concave.

5. Dispositif selon l'une quelconque des revendications précédentes, **caractérisé en ce que** le premier matériau comprend un borure des terres rares.

6. Dispositif selon l'une quelconque des revendications 1 à 5, **caractérisé en ce que** la première zone de surface est formée par un corps façonné (14a) massif constitué par le premier matériau.

7. Dispositif selon l'une quelconque des revendications 1 à 5, **caractérisé en ce que** la première zone de surface est un constituant d'un corps composite.

8. Dispositif selon l'une quelconque des revendications précédentes, **caractérisé en ce que** le deuxième matériau comprend du graphite.

9. Dispositif selon l'une quelconque des revendications précédentes, **caractérisé en ce que** le deuxième matériau comprend un métal.

10. Dispositif selon l'une quelconque des revendications précédentes, **caractérisé en ce que** la première et la deuxième zone de surface sont séparées par une fente contournant la première zone de surface.

11. Dispositif selon l'une quelconque des revendications précédentes, **caractérisé en ce qu'**au moins le premier matériau est isolé thermiquement par une barrière thermique sur la face arrière des pièces refroidies du dispositif.

12. Dispositif selon la revendication 11, **caractérisé en ce que** la barrière thermique comprend au moins une fente (44 ; 54) pouvant être mise sous vide et/ou un isolant thermique (18 ; 56).

13. Dispositif selon l'une quelconque des revendications 1 à 11, **caractérisé en ce que** le gaz de travail de la décharge luminescente est un gaz noble ou de l'hydrogène.

14. Dispositif selon l'une quelconque des revendications précédentes, **caractérisé en ce que** sa puissance d'irradiation à une tension de fonctionnement constante ou pulsée est réglable au moyen de la variation du flux de gaz de travail de la décharge luminescente.

15. Dispositif selon l'une quelconque des revendications précédentes, **caractérisé par** un corps isolant électrique (19 ; 48 ; 58) qui présente des canaux de refroidissement (19a) séparés du potentiel de la cathode et un passage de haute tension (19b) étanche au vide.

16. Dispositif selon l'une quelconque des revendications précédentes, **caractérisé en ce que** le sens de propagation du rayon électronique (17) dans la chambre cathodique (13) peut être réglé par un champ magnétique transversal généré au moyen d'un système de bobines magnétiques (11b) dans la zone entre la cathode (14) et l'anode (15).

17. Dispositif selon la revendication 15, **caractérisé en ce que** le corps isolant est constitué par un matériau synthétique (48), une céramique d'oxyde ou du nitrure d'aluminium (58).
